Europäisches Patentamt

European Patent Office

Office européen des brevets

(19)

(11) **EP 0 221 617 B1**

(12) **EUROPÄISCHE PATENTSCHRIFT**

(45) Veröffentlichungstag und Bekanntmachung des Hinweises auf die Patenterteilung:
**28.02.1996 Patentblatt 1996/09**

(51) Int Cl.6: **H03H 17/02**

(21) Anmeldenummer: **86201913.0**

(22) Anmeldetag: **03.11.1986**

(54) **Digitales Tiefpassfilter**

Low-pass digital filter

Filtre passe-bas numérique

(84) Benannte Vertragsstaaten:
**DE FR GB IT**

(30) Priorität: **05.11.1985 DE 3539172**

(43) Veröffentlichungstag der Anmeldung:
**13.05.1987 Patentblatt 1987/20**

(73) Patentinhaber:
- **Philips Patentverwaltung GmbH**
  **D-22335 Hamburg (DE)**
  Benannte Vertragsstaaten:
  **DE**
- **Philips Electronics N.V.**
  **NL-5621 BA Eindhoven (NL)**
  Benannte Vertragsstaaten:
  **FR GB IT**

(72) Erfinder:
- **Johannes, Kurt-Joachim**
  **D-2000 Hamburg 61 (DE)**

- **Gutsmann, Rolf-Dieter**
  **D-2000 Hamburg 61 (DE)**
- **Deutschmann, Detlef**
  **D-2000 Hamburg 52 (DE)**
- **Warmuth, Otto Leo**
  **D-2000 Hamburg 20 (DE)**
- **Demmer, Walter-Heinrich**
  **D-8500 Nürnberg 10 (DE)**

(74) Vertreter: **Hartmann, Heinrich, Dipl.-Ing. et al**
**Philips Patentverwaltung GmbH,**
**Röntgenstrasse 24**
**D-22335 Hamburg (DE)**

(56) Entgegenhaltungen:
**EP-A- 0 105 998          EP-A- 0 135 066**

- **PATENT ABSTRACTS OF JAPAN, Band 1, Nr. 153, 8. Dezember 1977, Seite 8190 E 77;& JP-A-52 95 948**

## Beschreibung

Die Erfindung betrifft ein digitales Tiefpaßfilter gemäß dem Oberbegriff des patentanspruchs 1.

Ein solches Tiefpaßfilter ist aus der Zeitschrift "Elektronik", 14./15.07.1983, Seite 61 bis 64 bekannt und wird bei der Digital-Analog-Umsetzung von Audiosignalen verwendet. In das Tiefpaßfilter werden die Signale mit einer Frequenz von 44,1 kHz eingelesen und mit einer Frequenz von 176,4 kHz ausgelesen. Die Wortlänge des 16-Bit-Eingangssignals vergrößert sich durch die Multiplikation mit 12-Bit-Koeffizienten auf 28 Bit im Tiefpaßfilter. In einem nachgeschalteten Störgeräuschformer wird das Signal auf 14 Bit gerundet, die Rundungsfehler über ein Register zum Eingangssignal des Störgeräuschformers addiert und das gerundete Ausgangssignal einem Digital-Analog-Umsetzer zugeführt. Das Ausgangssignal der Schaltungsanordnung weist einen höheren Signal/Rausch-Abstand auf als ein Ausgangssignal von einem 14 Bit Digital-Analog-Umsetzer ohne Tiefpaßfilter und ohne Störgeräuschformer.

In der digitalen Videosignalverarbeitung ist eine Abtastfrequenz erwünscht, die gerade noch das Abtasttheorem erfüllt, um z.B. den Aufwand von Verzögerungselementen nicht unnötig zu erhöhen. Die heute für diesen Zweck geeigneten Analog-Digital-Umsetzer, die z.B. bei einer Farbträgerfrequenz von 4,43 MHz mit einer Abtastfrequenz von 13,5 MHz arbeiten, erzeugen ungeradzahlige Harmonische des Farbträgers, die sich im Helligkeitssignal störend bemerkbar machen. Insbesondere die dritte Harmonische des Farbträgers, die bei 13,3 MHz liegt, erweist sich als störend, da sie durch die Periodizität des Spektrum auch bei 0,2 MHz im Helligkeitssignal eine Störung verursacht. Die Störung der dritten Harmonischen des Farbträgers kann vermieden werden, wenn die Abtastfrequenz des Analog-Digital-Umsetzers erhöht wird. Um den Aufwand der nachfolgenden digitalen Schaltungen nicht zu erhöhen, kann das bekannte digitale Tiefpaßfilter zur Reduzierung der Abtastfrequenz hinzugefügt werden. Eine günstige Abtastfrequenz für den Analog-Digital-Umsetzer ergibt sich bei der Frequenz von 20,25 MHz. Bei einer weiteren Signalverarbeitung mit der Abtastfrequenz von 13,5 MHz müßte das digitale Tiefpaßfilter eine Reduzierung um den Faktor 1,5 vornehmen.

Der Erfindung liegt die Aufgabe zugrunde, ein digitales Tiefpaßfilter der eingangs genannten Art so auszubilden, daß bei einem Verhältnis der Frequenz des Eingangssignals zur Frequenz des Ausgangssignals das größer als eins und dessen doppelter Wert ungeradzahlig ist, das digitale Tiefpaßfilter mit wenig Aufwand realisiert wird.

Diese Aufgabe wird erfindungsgemäß durch die kennzeichnenden Merkmale des Patentanspruchs 1 gelöst.

In dem erfindungsgemäßen Tiefpaßfilter werden die Umschaltzeitpunkte bezüglich jedes n-ten Abastwertes symmetrisch gelegt, damit die Anzahl der Koeffizienten nicht größer als die Anzahl der Multiplizierer ist. Die Umschalter sind dabei so in die Schaltung eingefügt, daß z.B. während der ersten Stellung der Abtastwert am Eingang des ersten Registers mit einem ersten Koeffizienten und der Abtastwert am Ausgang des letzten Registers mit einem letzten Koeffizienten multipliziert wird und während einer zweiten Stellung der Abtastwert am Eingang des ersten Registers mit dem letzten Koeffizienten und der Abtastwert am Ausgang des letzten Registers mit den ersten Koeffizienten multipliziert wird. Die Teilfolge wird also während der zweiten Stellung der Umschalter mit gegenüber der ersten Stellung symmetrisch umgetauschten Koeffizienten multipliziert. Bei einer geraden Anzahl von Registern wird der Abtastwert des Registers, das in der Mitte der in Reihe geschalteten Register liegt, immer mit demselben Koeffizienten multipliziert, so daß hier kein Umschalter notwendig ist. Am Ausgang des ersten Addierers liegt ein Signal vor, das in nachgeordneten Schaltungen mit der doppelten Schaltfrequenz weiterverarbeitet wird. Die Wortlänge des Ausgangssignals des Tiefpaßfilters ist um die Wortlänge eines Koeffizienten erhöht worden.

Die Umschalter können jeweils vor einem der beiden Eingänge der Multiplizierer angeordnet werden. Ein Eingang der Multiplizierer kann dabei mit wenigstens einem einen Koeffizienten speichernden Festwertspeicher gekoppelt sein.

Das Tiefpaßfilter kann in einem Fernsehempfänger zur Abtastfrequenzreduzierung eines Analog-Digital-Umsetzers verwendet werden, der mit einem Videodemodulator gekoppelt ist. Es hat sich in der Praxis für diesen Anwendungsfall gezegt, daß es genügt, wenn die Anzahl m der Register bei einem Verhältnis der Abtastfrequenz zur Schaltfrequenz von drei gleich fünf ist.

In einer Weiterbildung der Erfindung ist vorgesehen, daß der Ausgang des ersten Addierers mit einem ersten Störgeräuschformer gekoppelt ist, der einen zweiten Addierer umfaßt, dem das Ausgangssignal des ersten Addierers und dem die durch mindestens ein weiteres Register, das ein zweites Taktsignal mit einer doppelt so großen Taktfrequenz wie die Schaltfrequenz erhält, geleiteten niederwertigen Bits des Ausgangssignals des zweiten Addierers zugeführt werden. Der Störgeräuschformer verschiebt einen Teil des Rauschsignals aus dem Frequenzbereich, in dem das Tiefpaßfilter seinen Durchlaßbereich hat, in einen höherfrequenten Bereich, wie das auch aus Bild 2 der oben genannten Veröffentlichung bekannt ist.

Wie es sich in praktischen Versuchen gezeigt hat, ist es insbesondere wichtig, das Rauschen im Helligkeitssignal zu verringern. Daher ist vorgesehen, daß vor dem ersten Störgeräuschformer ein weiterer Tiefpaß zur Unterdrückung des Farbartsignals angeordnet ist. Zur Gewinnung des Farbartsignals wird dann der Ausgang des ersten Addierers mit einem Bandpaß zum Durchlassen des Farbartsignals verbunden.

Durch einen zweiten Störgeräuschformer läßt sich nun auch das Rauschen im Farbartsignal verringern. Dazu ist vorgesehen, daß der Ausgang des Bandpasses mit einem zweiten Störgeräuschformer verbunden ist, der einen dritten Addierer umfaßt, dem das Ausgangssignal des ersten Addierers und dem die durch mindestens zwei weitere in Reihe geschaltete Register, die das zweite Taktsignal erhalten, geleiteten nie erwertigen Bits des Ausgangssignals des dritten Addierers zugeführt werden.

Anhand der Zeichnungen werden im folgenden Ausführungsbeispiele beschrieben. Es zeigen:

Fig. 1einen Teil eines Fernsehempfängers mit dem erfindungsgemäßen digitalen Tiefpaß,

Fig. 2 ein erstes Ausführungsbeispiel der Erfindung,

Fig. 3 Diagramme zur Erläuterung der Fig. 2,

Fig. 4 einen Frequenzgang des digitalen Tiefpaßfilters nach Fig. 2,

Fig. 5 und 6 zwei Rauschspektren und

Fig. 7 ein zweites Ausführungsbeispiel der Erfindung.

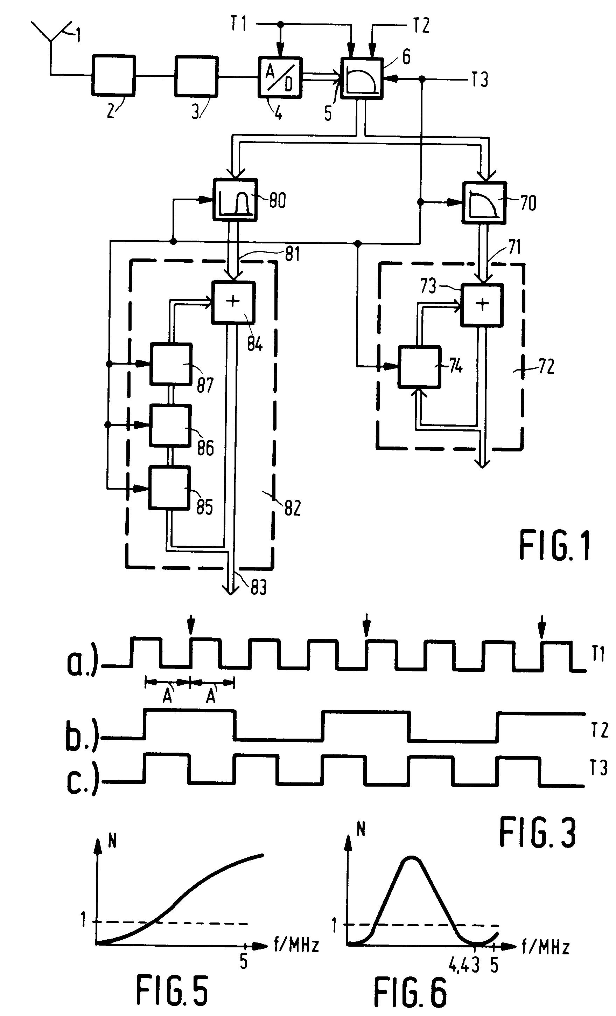

In Fig. 1 wird ein hochfrequentes Videosignal von einer Antenne 1 empfangen und einer Schaltung 2 zugeführt, die enen Tuner, einen Bildzwischenfrequenzverstärker und -demodulator enthält. Das zwischenfrequente Fernsehsignal wird in einem Videodemodulator 3 in das niederfrequente Fernsehsignal umgewandelt. In einem nachgeschalteten Analog-Digital-Umsetzer 4 wird das analoge Signal in ein digitales umgewandelt, das am Ausgang des Umsetzers 4 als Folge binär codierter Abtastwerte vorliegt. Das digitale Ausgangssignal des Analog-Digital-Umsetzers 4, dessen Abtastfrequenz 20,25 MHz beträgt, weist eine Auflösung von 7 Bit auf und wird dem Eingang 5 eines digitalen Tiefpasses 6 zugeführt.

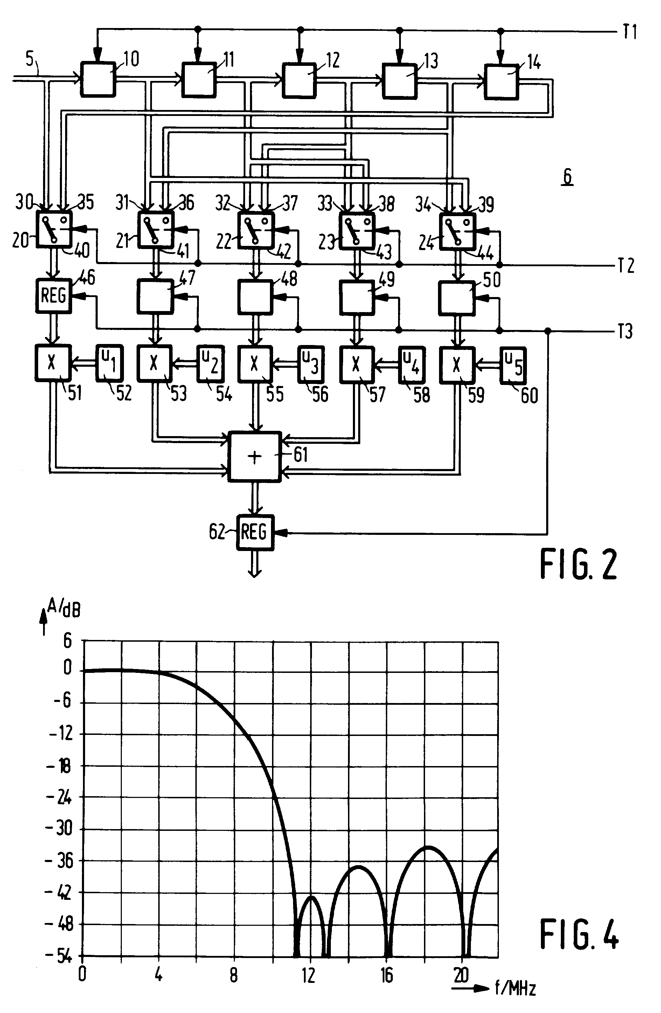

In Fig. 2 ist ein erstes Ausführungsbeispiel des digitalen Tiefpaßfilters 6 dargestellt. Der Eingang 5 des Tiefpaßfilters ist auch der Eingang eines Registers 10 und der erste Eingang 30 eines Umschalters 20. Dem Register 10 sind noch vier weitere Register 11 bis 14 in Reihe nachgeschaltet. Der Ausgang des Registers 10 ist mit dem ersten Eingang 31 eines Umschalters 21, der Ausgang des Registers 11 mit dem ersten Eingang 32 eines Umschalters 22, der Ausgang des Registers 12 mit dem ersten Eingang 33 eines Umschalters 23 und der Ausgang des Registers 13 mit dem ersten Eingang 34 eines Umschalters 24 verbunden. Des weiteren ist der Ausgang des Registers 14 mit dem zweiten Eingang 35 des Umschalters 20, der Ausgang des Registers 13 mit dem zweiten Eingang 36 des Umschalters 21, der Ausgang des Registers 12 mit dem zweiten Eingang 37 des Umschalters 22, der Ausgang des Registers 11 mit dem zweiten Eingang 38 des Umschalters 23 und schließlich der Ausgang des Registers 10 mit dem Eingang 39 des Umschalters 24 verbunden. Den Registern 10 bis 14 wird noch das Taktsgnal T1 mit einer Frequenz von 20,25 MHz zugeführt.

Die Ausgangssignale der Umschalter 20 bis 24 werden jeweils Registern zugeführt, d.h. der Ausgang 40 des Umschalters 20 ist mit einem Register 46, der Ausgang 41 des Umschalters 21 mit einem Register 47, der Ausgang 42 des Umschalters 22 mit einem Register 48, der Ausgang 43 des Umschalters 23 mit einem Register 49 und der Ausgang 44 des Umschalters 24 mit einem Register 50 verbunden. Den Umschaltern 20 bis 24 wird ein Schaltsignal T2 zugeführt, dessen Frequenz 6,75 MHz beträgt. Während einer ersten Stellung der Umschalter 20 bis 24 wird jeweils der erste Eingang eines Umschalters mit dem Ausgang und während der zweiten Stellung jeweils der zweite Eingang mit dem Ausgang verbunden. Den Registern 46 bis 50 wird noch ein Taktsignal T3 zugeführt, dessen Frequenz 13,5 MHz beträgt.

Die Ausgangssignale der Register 46 bis 50 werden jeweils in einem Multiplizierer mit jeweils einem einem Multiplizierer zugeordneten und in einem Festwertspeicher gespeicherten Koeffizienten multipliziert. Ein Multiplizerer 51 ist folglich mit einem Festwertspeicher 52 und dem Register 46, ein Multiplizierer 53 mit einem Festwertspeicher 54 und dem Register 47, ein Multiplizierer 55 mit einem Festwertspeicher 56 und dem Register 48, ein Multiplizierer 57 mit einem Festwertspeicher 58 und dem Register 49 und ein Multiplizierer 59 mit einem Festwertspeicher 60 und dem Register 50 verbunden. In den Festwertspeichern 52, 54, 56, 58 und 60 sind jeweils die Koeffizienten $u_1$ bis $u_5$ gespeichert. Die Ausgangssignale der Multiplizierer 51, 53, 55, 57 und 59 werden in einem Addierer 61 verknüpft. Das Ergebnis der Addition im Addierer 61 wird einem Register 62 zugeführt, das auch das Taktsignal T3 erhält.

Ein sechster Umschalter, dessen erster Eingang eine Verbindung mit dem Ausgang des Registers 14 und dessen zweiter Eingang eine Verbindung mit dem Eingang 5 des Registers 10 aufweist, ein mit dem Ausgang dieses Umschalters verbundenes sechstes Register und ein daran gekoppelter sechster Multiplizierer und sechster Festwertspeicher sind nicht erforderlich, da, wie weiter unten gezeigt wird, der Koeffizient $u_6$ ungefähr Null ist.

In Fig. 3 ist der zeitliche Verlauf der drei Taktsignale T1, T2 und T3 dargestellt, mit deren Hilfe das digitale Tiefpaßfilter von Fig. 2 erläutert wird. Mit jeder positiven Flanke des Taktsignals T1 wird in die Register 10 bis 14 ein neuer Abtastwert eingelesen. Die Abtastwerte, die über die Umschalter 20 bis 24 geleitet werden, werden mit jeder positiven Flanke des Taktsignals T3 in die Register 46 bis 50 eingelesen.Gleichzeitig werden auch die Umschalter 20 bis 24 durch das Taktsignal T2 umgeschaltet. Die Umschalter liegen in der ersten Stellung, nachdem eine positive Flanke des Taktsignals T2 vorgekommen ist und in der zweiten Stellung, nachdem eine negative Flanke des Taktsignals T2 vorgekommen ist. Ein neuer Abtastwert wird also nach jeder Umschaltung berechnet. Die Umschaltzeitpunkte sind so gewählt, daß sie jeweils symmetrisch zu bestimmten positiven Bezugsflanken des Taktsignals T1 liegen. In Fig. 3 sind solche positiven Bezugsflanken durch Pfeile gekennzeichnet. Die Umschaltzeitpunkte der Umschalter sind, wie oben erwähnt, die negativen und positiven Flanken des Taktsignals T2. Der zeitliche Abstand zwischen einer Bezugsflanke und den beiden Umschaltzeitpunkten ist gleich und in Fig. 3 ist dieser Abstand mit A gekennzeichnet und beträgt 3/4 einer Periode eines Taktsignals T1. Durch diese Wahl der zeitlichen Aufeinanderfolge der Taktsignale T1 und T2 und damit auch des Taktsignals T3 ist die Anzahl der Koeffizienten gleich der Anzahl der Multiplizierer.

Wie oben erwähnt, wird mit Hilfe des digitalen Tiefpaßfilters die Abtastfrequenz um den Faktor 1,5 reduziert und Frequenzkomponenten, die nicht im interessierenden Frequenzbereich (bis 5 MHz) liegen, unterdrückt. Die Koeffizienten für das Tiefpaßfilter können mit folgender Formel berechnet werden:

$$f(t) = \sum_{n=-N+1}^{N} f(n) * d(n) \qquad (1)$$

$$\text{mit } d(n) = g1(n) * g2(n) \qquad (2)$$
$$\text{und } g1(n) = \sin((t-n)C * \pi) / ((t-n)\,\pi), \qquad (3)$$
$$g2(n) = 0,54 + 0,46 * \cos(\pi\,(n-t)/N), \qquad (4)$$

wobei $-N+1 \leq n \leq N$ ist und f(n) die Teilfolge ist, die in den Registern 10 bis 14 gespeichert ist. f(t) ist der berechnete Abtastwert am Ausgang des Tiefpaßfilters 6. Mit t wird der Abstand zwischen einer positiven Flanke des Taktsignals T1 und dem darauf folgenden Umschaltzeitpunkt bezeichnet, bezogen auf eine Periode des Taktsignals T1, die gleich 1 ist. t kann die Werte 0,25 und 0,75 annehmen. d(n) ist die Folge der Koeffizienten. Die Funktion g1(n) ist die Fourier-Transformierte der Rechteckfunktion im Frequenzbereich. Ein ideales Tiefpaßfilter wird im Frequenzbereich durch eine solche Rechteckfunktion dargestellt. Da mit einer endlichen Anzahl von Abtastwerten gerechnet wird, ergibt sich im Frequenzbereich nicht der Frequenzgang eines idealen Tiefpaßfilters. Daher wird die Funktion g1(n) mit einer Fensterfunktion g2(n) gewichtet. Hier ist als Fensterfunktion g2(n) ein Hamming-Fenster verwendet worden. Die Bandbreite des Tiefpaßfilters wird noch durch den Faktor C in Gleichung (3) bestimmt, für den 0,7 gewählt worden ist.

Für das in Fig. 2 dargestellte Tiefpaßfilter wurden die folgenden Koeffizienten berechnet:

| t = 0,25: | | t = 0,75: | |
|---|---|---|---|
| n | d(n) | n | d(n) |
| -2 | -0,0619 | -2 | -0,0026 |
| -1 | 0,0642 | -1 | -0,0497 |
| 0 | 0,6548 | 0 | 0,3661 |
| 1 | 0,3661 | 1 | 0,6548 |
| 2 | -0,0497 | 2 | 0,0642 |
| 3 | -0,0026 | 3 | -0,0619 |

Da der Koeffizient für d(3) bei t = 0,25 und damit für d(-2) bei t = 0,75 sehr klein ist, wurde dieser gleich Null gesetzt und damit ein Multiplizierer eingespart. In Fig. 2 ist deshalb auch kein sechster Umschalter verwendet worden, der zwischen dem Eingang des ersten und dem Ausgang des letzten Registers wechselt.

Durch die Wahl der Umschaltzeitpunkte, die symmetrisch um einen Bezugsabtastwert liegen, ist die Folge d(n) der Koeffizienten für t = 0,25 und t = 0,75 umgekehrt gleich. Für die Berechnung der Koeffizienten ist es erforderlich, den zeitlichen Abstand t mit 0,25 und 0,75 festzulegen, um die exakten Werte zu berechnen. Bei der praktischen Realisierung können die Taktsignale T1 und T2 und damit auch T3 etwas verschoben werden, da nur sichergestellt werden muß, daß die Multiplikation der Abtastwerte mit den gleichen Koeffizienten vorgenommen wird, wie bei der symmetrischen Lage der Umschaltzeitpunkte zu den Bezugsabtastwerten.

Mit der erfindungsgemäßen Schaltungsanordnung ist es auch möglich, eine Frequenzreduzierung um einen Faktor durchzuführen, der größer als 1,5 ist. Die Schaltung ist besonders dann vorteilhaft anzuwenden, wenn eine Reduzierung um einen Faktor vorgenommen wird, der gleich dem Verhältnis w/2 der Frequenz des Eingangssignals und der Frequenz des Ausgangssignals ist, wobei w eine ungerade ganze Zahl ist. In diesem Fall ist die Anzahl der Koeffizienten nämlich nicht größer als die Anzahl der Multiplizierer.

Um die Multiplikation so einfach wie möglich zu gestalten, wurden letzlich für die Koeffizienten die untenstehenden Werte gewählt. Zur Vereinfachung sind die Koeffizienten folgendermaßen bezeichnet worden:

$$d(n, t = 0,25) = u_{n+3} \qquad (5)$$

Es ergeben sich für die Koeffizienten $u_1$ bis $u_5$ die Werte:

$$u_1 = -0{,}0625$$

$$u_2 = 0{,}0703$$

$$u_3 = 0{,}672$$

$$u_4 = 0{,}3906$$

$$u_5 = -0{,}0703$$

Der Frequenzgang des Tiefpaßfilters für diese Koeffizienten ist in Fig. 4 dargestellt. Soll ein anderer Frequenzgang des Tiefpaßfilters realisiert werden, müssen andere Koeffizienten berechnet werden.

Das Ausgangssignal des digitalen Tiefpaßfilters 6 wird, wie aus Fig. 1 ersichtlich, einem digitalen Tiefpaßfilter 70 zugeführt, das das Farbartsignal unterdrückt. Der Ausgang des Tiefpaßfilters 70 ist mit dem Eingang 71 eines Störgeräuschformers 72 verbunden. Dieser Störgeräuschformer 72 enthält einen Addierer 73 und ein Register 74. Am Eingang 71 des Störgeräuschformers 72, der auch ein Eingang des Addierers 73 ist, liegen jeweils Abtastwerte von z.B. 15 Bit vor. Durch die Multiplikation mit den Koeffizienten im Tiefpaßfilter 6 ist das Eingangssignal von 7 Bit auf 15 Bit erhöht worden. Dem anderen Eingang des Addierers 73 wird noch das Ausgangssignal des Registers 74 zugeführt. Die höchstwertigen 7 Bit des Ausgangssignals des Addierers 73 bilden das Ausgangssignal des Störgeräuschformers 72. Die niederwertigen 8 Bit werden dem Register 74 zugeleitet. Das Tiefpaßfilter 70 und das Register 74 erhalten noch das Taktsignal T3.

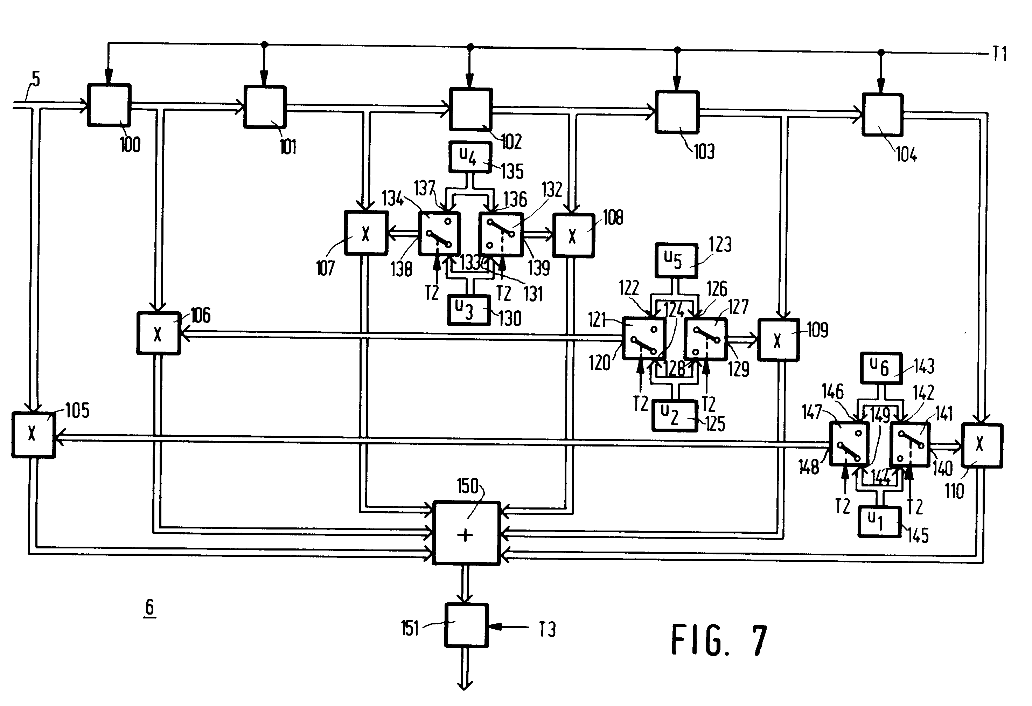

Das Ausgangssignal des Störgeräuschformers 72 ist das Helligkeitssignal, das auf 7 Bit gerundet worden ist. Die niederwertigen Bits werden über das Register 74 dem Addierer 73 wieder zugeführt und dem Eingangssignal hinzugefügt. Wie in der oben erwähnten Zeitschrift beschrieben ist, verbessert sich durch den Störgeräuschformer der Signal/Rausch-Abstand, indem das Störgeräusch aus dem interessierenden Frequenzbereich in einen anderen Frequenzbereich gelegt wird. In Fig. 5 ist die Wirkungsweise des Störgeräuschformers 72 dargestellt. In dieser Zeichnung ist das Rauschen N über den interessierenden Frequenzbereich gezeigt. Ohne Störgeräuschformer würde das Signal ein konstantes Rauschspektrum bei N = 1 aufweisen, wie das durch die gestrichelte Linie schematisch angedeutet ist. Der Störgeräuschformer 72 verringert das Rauschen bei niederfrequenten Signalen und erhöht es bei höherfrequenten.

Des weiteren ist das Tiefpaßfilter 6 mit einem Bandpaß 80 verbunden, der nur das Farbartsignal durchläßt. Der Ausgang des Bandpasses 80 ist mit dem Eingang 8l eines Störgeräuschformers 82 verbunden, an dessen Ausgang 83 das Farbartsignal zur Verfügung steht. Der Störgeräuschformer 82 umfaßt einen Addierer 84 und drei Register 85, 86 und 87. Der Eingang 81 des Störgeräuschformers 82 ist auch ein Eingang des Addierers 84. Am Ausgang 83 des Störgeräuschformers 82 werden nur die höchstwertigen 7 Bit des l5 Bit Ausgangssignals des Addierers 84 verwendet. Die niederwertigen 8 Bit werden über das Register 85, das Register 86 und das Register 87 dem anderen Eingang des Addierers 84 zugeführt. Den Registern 85, 86 und 87 und dem Bandpaß 80 werden noch das Taktsignal T3 zugeleitet. Der Störgeräuschformer 82 reduziert das Rauschen in dem Frequenzbereich um den Farbträger von 4,43 MHz und erhöht das Rauschen im Bereich von 2 bis 3 MHz. Das ist auch schematisch in Fig. 6 dargestellt.

In dem Tiefpaßfilter 70 und dem Bandpaßfilter 80 entsteht ebenfalls durch die Multiplikation mit Koeffizienten eine Vergrößerung der Wortlänge. Durch Abschneiden läßt sich die Wortlänge wieder reduzieren.

Das Ausgangssignal des Tiefpaßfilters 6 kann auch direkt auf den Störgeräuschformer 72 gegeben werden. Hierbei wird der Signal/Rausch-Abstand des niederfrequenten Helligkeitssignals verbessert und der des höherfrequenten Helligkeitssignals und des Farbartsignals etwas verschlechtert.

Ein zweites Ausführungsbeispiel des digitalen Tiefpaßfilters 6 ist in Fig. 7 gezeigt. Der Eingang 5 des Tiefpaßfilters ist auch gleichzeitig der Eingang eines Registers 100 und eines Multipliziers 105. Dem Register 100 sind Register 101, 102, 103 und 104 in Reihe nachgeschaltet. Jedes Register 100 bis 104 erhält außerdem noch das Taktsignal T1. Das Ausgangssignal des Registers 100 wird dem einen Eingang eines Multplizierers 106 zugeführt, dessen anderer Eingang mit dem Ausgang 120 eines Umschalters 121 verbunden ist. Der Eingang 122 des Umschalters 121 ist mit einem Festwertspeicher 123 und der Eingang 124 des Umschalters mit einem Festwertspeicher 125 verbunden. Der Festwertspeicher 123 ist noch mit dem Eingang 126 eines Umschalters 127 und der Festwertspeicher 125 mit dem Eingang 128 des Umschalters 127 verbunden. Der Ausgang 129 des Umschalters 127 ist mit dem einen Eingang eines Multiplizierers 109 verbunden, dessen anderem Eingang das Ausgangssignal des Registers 103 zugeführt wird.

Ein weiterer Festwertspeicher 130 ist jeweils mit dem Eingang 131 eines Umschalters 132 und mit dem Eingang 133 eines Umschalters 134 verbunden. Ein Festwertspeicher 135 stellt eine Verbindung mit dem Engang 136 des Umschalters 132 und mit dem Eingang 137 des Umschalters 134 her. Der Ausgang 138 des Umschalters 134 ist mit einem Eingang eines Multiplizierers 107, dessen anderem Eingang das Ausgangssignal des Registers 101 zugeführt wird, und der Ausgang 139 des Umschalters 132 mit dem einen Eingang eines Multiplizierers 108 verbunden, dessen anderem

5

Eingang das Ausgangssignal des Registers 102 zugeleitet wird.

Der Ausgang des letzten Registers 104 ist noch mit einem Eingang eines weiteren Multiplizierers 110 verbunden, dessen anderer Eingang mit dem Ausgang 140 eines Umschalters 141 verbunden ist. Der eine Eingang 142 des Umschalters 140 weist eine Verbindung mit einem Festwertspeicher 143 auf und der andere Eingang 144 hat eine Verbindung mit einem Festwertspeicher 145. Der Eingang 146 eines Umschalters 147, dessen Ausgang 148 mit dem anderen Eingang des Multiplizierers 105 eine Verbindung herstellt, ist mit dem Festwertspeicher 143 und der Eingang 149 des Umschalters 147 mit dem Festwertspeicher 145 verbunden. Die Ausgangssignale der Multiplizier 105 bis 110 werden in einem Addierer 150 verknüpft. Das Ausgangssignal des Addierers 150 wird einem weiteren Register 151 zugeleitet. Am Ausgang des Registers 151 steht dann das Ausgangssignal des Tiefpasses zur Verfügung. Die Umschalter 121, 127, 132, 134, 141 und 147 werden von dem Taktsignal T2 gesteuert und dem Register 151 wird das Taktsignal T3 zugeleitet.

Während der ersten Stellung ist der Ausgang 120 des Umschalters 121 mit dem Eingang 124, der Ausgang 129 des Umschalters 127 mit dem Eingang 126, der Ausgang 139 des Umschalters 132 mit dem Eingang 136, der Ausgang 138 des Umschalters 134 mit dem Eingang 133, der Ausgang 140 des Umschalters 141 mit dem Engang 142 und der Ausgang 148 des Umschalters 147 mit dem Eingang 149 verbunden. In der zweiten Stellung ist dann der Ausgang jedes Umschalters mit dem jeweils anderen Eingang verbunden. In den Festwertspeichern 123, 125, 130, 135 und 145 sind die Koeffizienten $u_1$ bis $u_5$ abgespeichert. Für den sechsten Koeffizienten steht der Festwertspeicher 143 zur Verfügung, der, wie oben ausgeführt, gleich Null ist.

## Patentansprüche

1.  Digitales Tiefpaßfilter mit m in Reihe geschalteten Registern (10 bis 14; 100 bis 104), deren erstem Register (10; 100) ein digitales Eingangssignal zugeführt wird, das als Folge amplitudendiskreter Abtastwerte mit einer durch ein erstes Taktsignal (T1) bestimmten ersten Abtastfrequenz vorliegt, mit Multiplizierern (51, 53, 55, 57, 59; 105 bis 110), die die Teilfolge der jeweils am Eingang des ersten Registers und an den Ausgängen der Register anliegenden Abtastwerte mit einer durch ein drittes Taktsignal (T3) bestimmten dritten Abtastfrequenz mit Koeffizienten (u1 bis u5) multiplizieren, und mit einem ersten Addierer (61; 150), dem die Ausgangssignale der Multiplizierer zugeführt werden,

    **dadurch gekennzeichnet,** daß an einem der beiden Eingänge jedes Multiplizierers je ein Umschalter (20 bis 24; 121, 127, 132, 134, 141, 147) so angeordnet ist, daß in der einen Stellung des Umschalters der j-te Abtastwert der Teilfolge und in der anderen Stellung der k-te Abtastwert der Teilfolge mit jeweils dem gleichen Koeffizienten multipliziert wird, wobei $1 \leq j \leq m + 1$ und $1 \leq k \leq m + 1$ gilt und $j + k = m + 2$ ist, daß das Verhältnis n der ersten Abtastfrequenz zur der Frequenz eines zweiten Taktsignals (T2) entsprechenden Schaltfrequenz der Umschalter größer als zwei und ganzzahlig ist und daß die beiden Umschaltzeitpunkte der Umschalter jeweils symmetrisch zu jedem n-ten Abtastzeitpunkt der mit der ersten Abtastfrequenz auftretenden Folge der amplitudendiskreten Abtastwerte liegen.

2.  Digitales Tiefpaßfilter nach Anspruch 2,
    dadurch gekennzeichnet, daß die Umschalter jeweils vor dem Eingang der Multiplizierer angeordnet sind, dem jeweils ein Abtastwert der Teilfolge zugeführt wird (Fig. 2).

3.  Digitales Tiefpaßfilter nach Anspruch 2,
    dadurch gekennzeichnet, daß die Umschalter jeweils vor dem Eingang der Multplizierer angeordnet sind, dem jeweils ein Koeffizient zugeführt wird (Fig. 7).

4.  Digitales Tiefpaßfilter nach einem der vorhergehenden Ansprüche, dadurch gekennzeichnet, daß jeweils ein Eingang der Multiplizierer mit wenigstens einem einen Koeffizienten speichernden Festwertspeicher (52, 54, 56, 58, 60; 123, 125, 130, 135, 143, 145) gekoppelt ist.

5.  Digitales Tiefpaßfilter nach einem der vorhergehenden Ansprüche, dadurch gekennzeichnet, daß die Anzahl m der Register gleich fünf ist und daß das Verhältnis n der Abtastfrequenz zur Schaltfrequenz gleich drei ist.

6.  Farbfernsehempfänger mit einem digitalen Tiefpaßfilter nach einem der vorhergehenden Ansprüche, dadurch gekennzeichnet, daß ein Videodemodulator (3) mit einem A/D-Umsetzer (4) gekoppelt ist, dessen Ausgang mit dem ersten Register verbunden ist.

7.  Farbfernsehempfänger mit einem digitalen Tiefpaßfilter nach Anspruch 6, dadurch gekennzeichnet, daß der Ausgang des ersten Addierers mit einem ersten Störgeräuschformer (72) gekoppelt ist, der einen zweiten Addierer (73) umfaßt, dem das Ausgangssignal des ersten Addierers und dem die durch mindestens ein weiteres Register (74), das ein zweites Taktsignal mit einer doppelt so großen Taktfrequenz wie die Schaltfrequenz erhält, geleiteten niederwertigen Bits des Ausgangssignals des zweiten Addierers zugeführt werden.

8. Farbfernsehempfänger mit einem digitalen Tiefpaßfilter nach Anspruch 7, <u>dadurch gekennzeichnet</u>, daß vor dem ersten Störgeräuschformer ein weterer Tiefpaß (70) zur Unterdrückung des Farbartsignals angeordnet ist.

9. Farbfernsehempfänger mit einem digitalen Tiefpaßfilter nach einem der Ansprüche 7 und 8, <u>dadurch gekennzeichnet</u>, daß der Ausgang des ersten Addierers mit einem Bandpaß (80) zum Durchlassen des Farbartsignals angeordnet ist.

10. I0. Farbfernsehempfänger mit einem digitalen Tiefpaßfilter nach Anspruch 9, <u>dadurch gekennzeichnet</u>, daß der Ausgang des Bandpasses mit einem zweiten Störgeräuschformer (82) verbunden ist, der einen dritten Addierer (84) umfaßt, dem das Ausgangssignal des ersten Addierers und dem die durch mindestens zwei weitere in Reihe geschaltete Register (85, 86, 87), die das zweite Taktsignal erhalten, geleiteten niederwertigen Bits des Ausgangssignals des dritten Addierers zugeführt werden.

## Claims

1. A digital low-pass filter comprising m series-arranged registers (10 to 14; 100 to 104), a digital input signal, which is present as a sequence of amplitude-discrete sampling values having a first sampling frequency determined by a first clock signal (T1), being applied to the first (10; 100) of these registers, multipliers (51, 53, 55, 57, 59; 105 to 110) multiplying the sub-sequence of sampling values present at the input of the first register and at the outputs of the registers and having a third sampling frequency determined by a third clock signal (T3) by coefficients ($u_1$ to $u_5$), and a first adder (61; 150) to which the output signals of the multipliers are applied, characterized in that a change-over switch (20 to 24; 121, 127, 132, 134, 141, 147) is arranged at one of the two inputs of each multiplier in such a way that in one position of the change-over switch the $j^{th}$ sampling value of the sub-sequence and in the other position the $k^{th}$ sampling value of the subsequence are always multiplied by the same coefficient, wherein $1 \leq j \leq m + 1$ and $1 \leq k \leq m + 1$ and $j + k = m + 2$, in that the ration between the first sampling frequency and the switching frequency of the changeover switch corresponding to the frequency of a second clock signal (T2) exceeds two and is an integral number, and in that the two switching instants of the change-over switches are symmetrical with respect to each $n^{th}$ sampling instant of the sequence of amplitude-discrete sampling values occurring at the first sampling frequency.

2. A digital low-pass filter as claimed in claim 2, characterized in that the change-over switches precede the inputs of the multipliers to which a sampling value of the sub-sequence is applied (Fig. 2).

3. A digital low-pass filter as claimed in Claim 2, characterized in the change-over switches precede the inputs of the multipliers to which a coefficient is applied (Fig. 7).

4. A digital low-pass filter as claimed in any one of the preceding Claims, characterized in that one input of the multipliers is coupled to at least one read-only memory (52, 54, 56, 58, 60; 123, 125, 130, 135, 143, 145) in which a coefficient is stored.

5. A digital low-pass filter as claimed in any one of the preceding Claims, characterized in that the number m of the registers is equal to five and that the sampling frequency-to-switching frequency ratio n is equal to three.

6. A colour television receiver including a digital low-pass filter as claimed in any one of the preceding Claims, characterized in that a video demodulator (3) is coupled to an AID converter (4), whose output is connected to the first register.

7. A colour television receiver including a digital low-pass filter as claimed in Claim 6, characterized in that the output of the first adder is coupled to a first noise shaper (72) which comprises a second adder (73) to which the output signal of the first adder is applied an receives the less significant bits of the output signal of the second adder <u>via</u> at least one further register (74) which receives a second clock signal having a clock frequency which is double the switching frequency.

8. A colour television receiver including a digital low-pass filter as claimed in Claim 7, characterized in that a further low-pass filter (70) for suppressing the chrominance signal precedes the first noise shaper.

9. A colour television receiver including a digital low-pass filter as claimed in any one of Claims 7 and 8, characterized in that the output of the first adder is coupled to a bandpass filter (80) for transmitting the chrominance signal.

10. A colour television receiver including a digital low-pass filter as claimed in Claim 9, characterized in that the output of the bandpass filter is coupled to a second noise shaper (82), which comprises a third adder (84) to which the output signal of the first adder is applied and receives the less significant bits of the output signal of the third adder <u>via</u> at least two further series-arranged registers (85, 86, 87) which receive the second clock signal.

## Revendications

1. Filtre passe-bas numérique comportant m registres (10 à 14; 100 à 104) connectés en série, au premier registre duquel (10; 100) est acheminé un signal d'entrée numérique, qui est présent sous la forme d'une séquence de valeurs d'échantillonnage discrètes en amplitude à une première fréquence d'échantillonnage déterminée par un premier signal de cadence (T1), des multiplicateurs (51, 53, 55, 57, 59; 105 à 110), qui multiplient la séquence partielle des valeurs d'échantillonnage appliquées respectivement à l'entrée du premier registre et aux sorties des registres à une troisième fréquence d'échantillonnage déterminée par un troisième signal de cadence (T3) par des coefficients ($u_1$ à $u_5$), et un premier additionneur (61; 150), auquel les signaux de sortie des multiplicateurs sont acheminés, caractérisé en ce que, à l'une des deux entrées de chaque multiplicateur est chaque fois installé un commutateur (20 à 24; 121, 127, 132, 134, 141, 147), de telle sorte que dans la première position du commutateur, la $j^{ème}$ valeur d'échantillonnage de la séquence partielle et, dans l'autre position, la $k^{ème}$ valeur d'échantillonnage de la séquence partielle soient multipliées respectivement par le même coefficient, où $1 \leq j \leq m + 1$ et $1 \leq k \leq m + 1$ et $j + k = m + 2$, que le rapport n de la première fréquence d'échantillonnage à la fréquence d'un deuxième signal de cadence (T2) de fréquence de commutation correspondant à celle des commutateurs est supérieur à 2 et est un nombre entier et que les deux instants de commutation des commutateurs sont respectivement symétriques vis-à-vis de chaque $n^{ème}$ instant de commutation de la séquence des valeurs d'échantillonnage discrètes en amplitude qui apparaissent à la première fréquence d'échantillonnage.

2. Filtre passe-bas numérique selon la revendication 2, caractérisé en ce que les commutateurs sont agencés respectivement devant l'entrée des multiplicateurs à laquelle une valeur d'échantillonnage de la séquence partielle est chaque fois acheminée (Fig. 2).

3. Filtre passe-bas numérique selon la revendication 2, caractérisé en ce que les commutateurs sont agencés respectivement devant l'entrée des multiplicateurs à laquelle un coefficient est chaque fois acheminé (Fig. 7).

4. Filtre passe-bas numérique selon l'une quelconque des revendications précédentes, caractérisé en ce qu'une entrée des multiplicateurs est chaque fois couplée à au moins une mémoire morte (52, 54, 56, 58, 60; 123, 125, 130, 135, 143, 145) mémorisant un coefficient.

5. Filtre passe-bas numérique selon l'une quelconque des revendications précédentes, caractérisé en ce que le nombre m des registres est égal à cinq et le rapport n de la fréquence d'échantillonnage à la fréquence de commutation est égal à trois.

6. Récepteur de télévision couleur comportant un filtre passe-bas numérique selon l'une quelconque des revendications précédentes, caractérisé en ce qu'un démodulateur vidéo (3) est couplé à un convertisseur A/D (4) dont la sortie est connectée au premier registre.

7. Récepteur de télévision couleur comportant un filtre passe-bas numérique selon la revendication 6, caractérisé en ce que la sortie du premier additionneur est couplée à un premier conformateur de bruit (72), qui contient un deuxième additionneur (73), auquel sont appliqués le signal de sortie du premier additionneur et les bits de poids faible du signal de sortie du deuxième additionneur, guidés par au moins un autre registre (74), qui reçoit un deuxième signal de cadence d'une fréquence de commutation double de la fréquence de commutation.

8. Récepteur de télévision couleur comportant un filtre passe-bas numérique selon la revendication 7, caractérisé en ce qu'un autre filtre passe-bas (70) est agencé devant le premier conformateur de bruit pour supprimer le signal de chrominance.

9. Récepteur de télévision couleur comportant un filtre passe-bas numérique selon l'une ou l'autre des revendications 7 et 8, caractérisé en ce que la sortie du premier additionneur est agencée avec un passe-bande (80) pour laisser passer le signal de chrominance.

10. Récepteur de télévision couleur comportant un filtre passe-bas numérique selon la revendication 9, caractérisé en ce que la sortie du passe-bande est connectée à un deuxième conformateur de bruit (82) qui contient un troisième additionneur (84), auquel sont appliqués le signal de sortie du premier additionneur et les bits de poids faible du signal de sortie du troisième additionneur guidés via au moins deux autres registres (85, 86, 87) connectés en série, qui reçoivent le deuxième signal de cadence.

FIG.1

FIG.3

FIG.5

FIG.6

EP 0 221 617 B1

FIG. 2

FIG. 4

11

FIG. 7

EP 0 221 617 B1